## Europäisches Patentamt
## European Patent Office
## Office européen des brevets

(11) Publication number: **0 130 207**
**B1**

(12) EUROPEAN PATENT SPECIFICATION

(45) Date of publication of patent specification: **11.07.90**

(51) Int. Cl.⁵: **H 05 K 1/14**

(21) Application number: **84900350.4**

(22) Date of filing: **08.12.83**

(86) International application number:
**PCT/US83/01927**

(87) International publication number:
**WO 84/02631 05.07.84 Gazette 84/16**

(54) SEMICONDUCTOR CHIP PACKAGE.

(30) Priority: **29.12.82 US 454197**

(43) Date of publication of application:
**09.01.85 Bulletin 85/02**

(45) Publication of the grant of the patent:
**11.07.90 Bulletin 90/28**

(84) Designated Contracting States:
**BE DE FR NL SE**

(56) References cited:
**EP-A-0 011 406**   **US-A-3 867 759**
**US-A-3 568 000**   **US-A-4 047 132**
**US-A-3 643 201**   **US-A-4 210 885**
**US-A-3 740 678**   **US-A-4 353 040**

**IBM JOURNAL OF RESEARCH AND
DEVELOPMENT, vol. 26, no. 3, May 1982, pages
286-296, Armonk, New York, US; C.W. HO et al.:
"The thin-film module as a high-performance
semiconductor package"**

(73) Proprietor: **Western Electric Company,
Incorporated
222 Broadway
New York, NY 10038 (US)**

(72) Inventor: **RAINAL, Attilio, Joseph
28 Woodruff Road
Convent Station, NJ 07961 (US)**

(74) Representative: **Johnston, Kenneth Graham
et al
AT&T (UK) LTD. AT&T Intellectual Property
Division 5 Mornington Road
Woodford Green Essex, IG8 OTU (GB)**

(56) References cited:
**MICROWAVES, September 1968, Helmut E.
Brenner, USE A COMPUTER TO DESIGN
SUSPENDED SUBSTRATE ICs pp. 38 to 43 HO
relied on**

**BELL SYSTEM TECHNICAL JOURNAL, V. 58 No.
5, June 1979, A.J. RAINAL, TRANSMISSTION
PROPERTIES OF VARIOUS STYLES OF PRINTED
WIRING BOARDS, pp. 995 to 1025 relied on**

## Description

### Background of the invention

This invention relates to chip packages which interconnect semiconductor integrated circuit (IC) chips to printed wiring circuit boards, and, particularly, to high-speed, high pin-out chip packages.

To attach an integrated circuit chip of the large scale or very large scale integration type to a circuit board, the electrical contacts or wire bonds from the chip can be directly affixed to electrical contacts on the circuit board. The circuit board can include multiple layers of conductors separated by dielectric material, the layers comprising signal layers, a ground layer and a voltage supply layer. The impedance of the board can be set by controlling the thickness of the insulator separating the signal layer from the ground and voltage supply layers (see EP—A—0 011 406). For purposes of repair and testing, however, direct mounting of the IC chip on the circuit board is disadvantageous, since removal of the chip is difficult.

A preferable arrangement for mounting an IC chip to a circuit board is to affix one or more chips onto a chip package which, in turn, is affixed to the circuit board. Such a chip package can take the form of a mini-printed wiring board having a plurality of leads or pins, which attach to the circuit board. The transmission properties of such a chip package depend on the type or style of the physical arrangement of the package. As the operating speed of an integrated circuit chip increases, the transmission properties of the chip package become an important consideration. In particular, inductive noise between the chip package and the printed wiring board limits the physical design of the chip packages. Such noise becomes a problem when the rise time of the pulse signals transmitted between the chip and printed wiring board is 5 ns ($5 \times 10^{-9}$ sec) or less. Furthermore, as the number of pin-outs (signal, ground, and power leads) on a chip package increases, such signal distortion problems due to inductive noise are exacerbated as a result of decreased interconnector lead spacing and increased cross-talk.

The problem, then, is to design a high-speed, high pin-out chip package which has reduced inductive noise. By high speed is meant, generally, signal rise times faster than 5 ns, and by high pin-out is meant, generally, a number of pin-outs in excess of 60.

### Summary of the invention

In accordance with the present invention, a chip package, adapted to receive at least one integrated circuit chip thereon, comprises a laminate including at least one ground conductive layer, at least one power conductive layer, and at least one signal layer including spaced apart signal conductors. Layers of dielectric material separate adjacent conductive layers. The package is impedance-matched to a printed wiring board by selection of the width of each signal conductor and its distance to the nearest ground or power layer. Plural plated-through holes are disposed through the package for electrically interconnecting the signal conductors, the ground layer, and the power layer to the circuit board, and are arranged in a predetermined pattern to reduce inductive noise. In particular, the power and ground plated-through holes are located substantially symmetrically on the package, and each signal plated-through hole is located proximate to a power or ground plated-through hole.

### Brief description of the drawing

Fig. 1 is a chip carrier package in accordance with the present invention adapted to receive two integrated chips thereon; and

Fig. 2 is a cross-sectional view of the chip package of Fig. 1.

### Detailed description

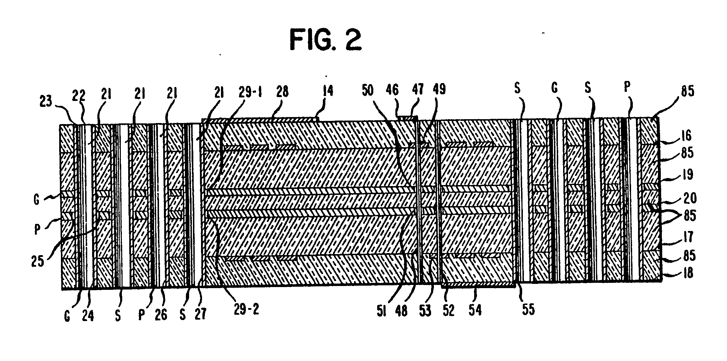

With reference to the Figs., a chip package 10 is shown that is designed to interconnect two high-speed, high pin-out integrated circuit chips (not shown) to a circuit board (not shown). The package comprises a laminate including six conductive layers identified by the reference numerals 15, 16, 17, 18, 19 and 20. Layers 15—18 each comprises (Fig. 2) a plurality of spaced apart conductors of, for example, copper, the purpose of which is hereinafter described, and these layers are hereinafter referred to as signal layers $S_1$, $S_2$, $S_3$ and $S_4$, respectively. Layers 19 and 20 each comprises a single film of conductive material, e.g., copper, layer 19 comprising a ground plane G for the package 10 and layer 20 providing a power plane P. A layer 85 of epoxy glass dielectric material is disposed between each of the layers 15—18.

Chip package 10 is adapted to have mounted thereupon two IC chips and to provide electrical interconnection of the signal, power, and ground inputs and outputs of the two chips to the circuit board when the chip package 10 is affixed thereto. In addition, chip package 10 provides direct electrical interconnection between the two chips, as required.

For receipt of, in this embodiment, two semiconductor chips, the chip package 10 includes sets 11 and 12 of contacts 14 on top surface 13. The contacts 14 in each set 11 and 12 are arranged in a rectangular pattern to match the corresponding pattern of contacts on the IC chip that is to be affixed thereon. In the particular embodiment disclosed herein, contact sets 11 and 12 are each adapted to receive high pin-out IC chips that have 84 input/output/power/ground leads with 21 leads on each side.

To provide certain electrical interconnects, the package 10 is provided, in this embodiment, with two arrays of plated-through holes; one such array comprising 8 parallel rows of holes, and the holes of the other array, referred to as "vias", being disposed among the first array. Each plated-through hole 21, as is standard in printed wiring board technology, includes an aperture 22, through the plural layers of the package 10, and a metallic plating 23, e.g., of copper, disposed on the inside walls of the aperture 22. Each plated-through hole in two rows 69 and 72 of the first array, such as, for example, plated-through hole 24 in Fig. 2, makes electrical contact with ground plane 19. The holes in rows 69 and 72 are thus referred to as "ground holes". A clearance hole 25 isolates the conductive plating 23 of the plated-through hole 24 from the power plane 20. Similarly, each plated-through hole in rows 70 and 71 of the first array, such as 26 in Fig. 2, makes electrical contact with power plane 20, and is isolated electrically from ground plane 19 by means of a clearance hole through that plane. These holes (rows 70 and 71) are referred to as "power holes".

Each plated-through hole of the remaining four rows 65, 66, 67, 68, such as hole 27 in Fig. 2, makes electrical contact with a conductor 28 which is connected to a signal contact 14. Clearance holes 29-1 and 29-2 through ground plane 19 and power plane 20, respectively, electrically isolate these holes ("signal") from the ground and power planes.

One purpose of the various ground, power and signal plated-through holes is to provide means for electrically connecting the various elements connected to the condutive platings 23 on the hole walls to conductive elements on the printed wiring circuit board onto which the chip package 10 is to be mounted. This can be accomplished by inserting conductive pins through the holes, which pins are then attached, as by soldering, both to the hole walls and to the circuit board conductive elements. Alternatively, the platings 23 at the bottom ends of the holes can be soldered directly to the board elements using, for example, solder balls.

The purpose of the "via" plated-through holes is to provide interconnection between various ones of the contacts 14 by means of the conductors on various ones of the signal layers 15—18. Also, in some instances, the via through holes provide parts of conductive paths serving to interconnect various ones of the contacts 14 to various ones of the ground, power and signal through holes.

In order to facilitate the routing of conductors on each signal layer and to prevent conductor cross-overs, conductors are routed on each signal layer in a single direction. Accordingly, the conductors in signal layers 15 and 18 run parallel to side edges 30 and 31; and the conductors in signal layers 16 and 17 run parallel to side edges 32 and 33.

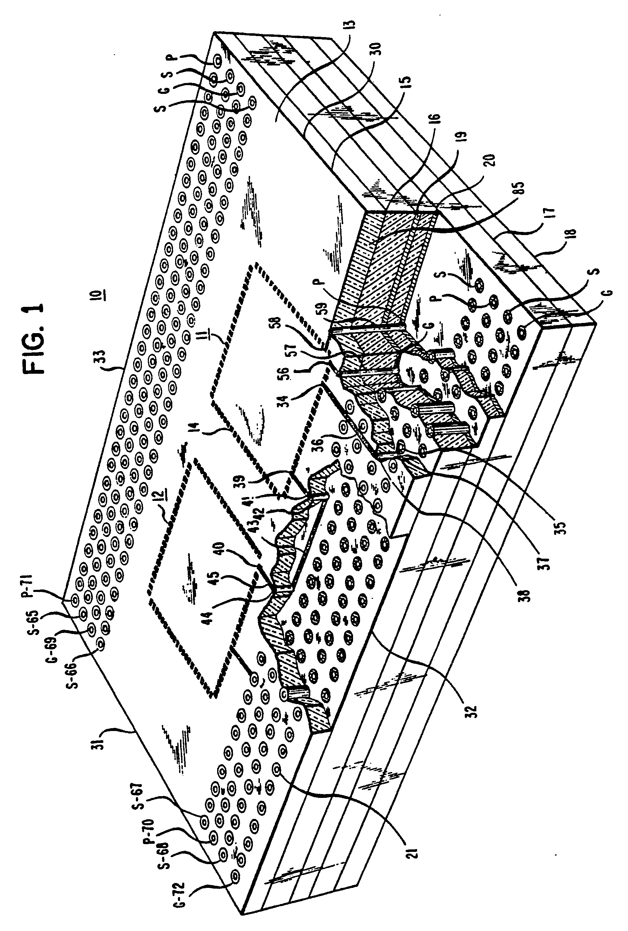

To preserve the clarity of the drawings, only a selected few of the many connections among the various conductive elements are shown. With reference to Fig. 1, and by way of illustration, one of the chip contacts 14, identified by the numeral 34, is connected to a signal plated-through hole 35 by means of a conductor segment 36 on signal layer 15, conductor segment 37 on signal layer 16, and via 38, which interconnects segments 36 and 37. Similarly, the electrical path between the chip contact 39 in contact set 11 and the chip contact 40 in contact set 12 includes conductor segment 41 on layer 15, conductor segment 43 on layer 16, and conductor segment 45 on layer 15. Via 42 interconnects segments 41 and 43, and via 44 interconnects segments 43 and 45.

As further illustration, with reference to Fig. 2, chip contact 46 is connected to conductor segment 47 on layer 15. Via 48 connects conductor segment 47 to conductor segment 49 on layer 16, conductor 49 being disposed perpendicularly to the plane of the cross-sectional cut of Fig. 2. Clearance holes 50 and 51 on ground plane 19 and power plane 20, respectively, isolate via 48 from these conductive planes. As another illustrative example, via 52 interconnects conductor 53 on layer 17 and conductor 54 on layer 18, the latter being connected to signal plated-through hole 55.

With reference again to Fig. 1, certain ground and power contacts 14 are connected directly by vias to the ground layer 19 and power layer 20, respectively. For example, ground chip contact 56 is connected by via 57 to ground plane 19, and power chip contact 58 is connected to power plane 20 by via 59.

As heretofore discussed, as the operating speed of an IC chip increases, and the number of pin-outs on a chip package increases, it is critical that the chip package be designed for reduced inductive noise. Inductive noise is minimized in chip package 10 by a two-fold design process: the chip package 10 is designed to be impedance-matched to the circuit board to which it is to be attached; and the plated-through holes 21 are distributed on the package 10 in accordance with a predetermined set of design rules.

As known, each style of printed wiring board has a characteristic impedance which is a function of several factors. The chip package 10 of the present invention is impedance-matched to the characteristic impedance of the particular circuit board to which it is to be attached by controlling the impedance of the conductors in each signal layer 15, 16, 17 and 18. The impedance of the signal conductors is controlled by selection of the width of the conductor, and the distance between the conductor and the nearest constant potential plane (i.e. ground and power planes 19 and 20).

Using embedded microstrip transmission line theory, the impedance of a conductor embedded within a dielectric and disposed over a constant potential plane can be derived. The relationship between impedance Z and the width $w$ of a conductor disposed a distance $h$ over a constant potential plane when embedded within epoxy glass having a dielectric coefficient $<_R$ of 4.2 has been derived from mathematical and experimental results to be:

$$Z = 25 \ln\left[\frac{8h}{w}\right] \qquad (1)$$

The general equation for a conductor embedded in a dielectric having a coefficient $<_R$ is given by:

$$.Z = \sqrt{4.2}/<_R \ln\left[\frac{8h}{w}\right]. \qquad (2)$$

From equations (1) and (2), it is apparent that the ratio of $h$ to $w$ must be substantially the same for the conductors in the different signal layers for the impedance of the conductors in each of the layers to be substantially the same. Therefore, for best impedance match, the width $w$ of the conductors in signal layers 15 and 18, which are further away from constant potential planes 19 and 20, respectively, is greater than the width of the conductors in the signal layers 16 and 17.

In order to reduce inductive noise between the chip package 10 and the circuit board to which it is to be attached, the signal, ground, and power plated-through holes are disposed throughout the package in a physical arrangement that satisfies three general rules. These rules are: (1) The ground plated-through holes and the power plated-through holes are separated from one another by signal plated-through holes, and (2) are located symmetrically on the chip package; and (3) the signal plated-through holes are located adjacent to the power and ground plated-through holes.

Application of these rules to chip package 10 is demonstrated by referring again to Fig. 1. The signal S plated-through holes are uniformly spaced in rows 65, 66, 67 and 68 parallel to side edges 32 and 33. A row 69 of ground G plated-through holes separates signal rows 65 and 66, and a row 70 of power P plated-through holes separates rows 67 and 68. A row 71 of power plated-through holes is disposed between signal row 65 and edge 33, and a row 72 of ground plated-through holes is disposed between signal row 68 and edge 32. The power and ground plated-through holes are thus separated by signal through holes and are symmetrically located. That is, if all power plated-through holes are made ground plated-through holes, and all ground plated-through holes are made power plated-through holes, the resultant arrangement of plated-through holes on package 10 remains unchanged. For example, in the arrangement shown in Fig. 1, the signal rows 65 and 68 each has a power and ground row 71, 69 and 70, 72, respectively, on either side thereof. The same arrangement exists upon the aforementioned interchange of ground and power hole connections. Also, the signal plated-through holes are located adjacent to power and ground plated-through holes. This arrangement, therefore, satisfies the aforenoted rules for reducing inductive noise.

Other arrangements of signal, power, and ground plated-through holes satisfying the above-noted rules can be developed.

Each signal plated-through hole is connected to a signal contact 14 in either contact set 11 or 12. The ground plated-through holes are connected directly to ground plane 19, and the power plated-through holes are connected directly to power plane 20. While generally, there is a one-to-one correspondence between signal plated-through holes and signal contact regions 14 (except for those interconnected signal contacts between sets 11 and 12, viz contacts 39 and 40), there are more ground and power plated-through holes than ground and power contact regions 14. These additional ground and power plated-through holes are disposed in package 10 in order to satisfy the above-noted rules for reducing inductive noise.

Fabrication of the package 10 is not described because techniques of fabricating laminated structures, including plated through holes, of the type described herein are known.

## Claims

1. A semiconductor chip package (10) comprising a plurality of dielectric layers (85), conductive contacts (14) on a surface (13) of one of said layers arranged for connection to a semiconductor chip to be mounted on said package, a conductive ground layer (19), a conductive power layer (20), and a pair of signal layers (16, 17) each disposed between a different pair of said dielectric layers, each of said signal layers including a plurality of spaced apart conductors (43, 37), and plated-through holes (21) extending through ones of said layers interconnecting different ones of said conductive contacts (14) with different ones of said conductive layers, characterized in that the ratio of the width of conductors (43) of one of said signal layers (16) to the distance of said one layer to the nearest one (19) of said ground and power layers (19, 20) is substantially equal to the ratio of the width of conductors of the other of said signal layers (17) to the distance of said other of said layers to the nearest one (20) of said ground and power layers.

2. The package according to claim 1, characterized in that the plated-through holes (71, 69) connected to said power and ground layers, respectively, are disposed symmetrically with respect to each other on said package, and each of said power-connected and ground-connected through holes is separated by a plated-through hole (65) interconnected to one of said signal layers.

3. The package according to claim 2 characterized in that each of the plated-through holes (65—68) connected to a signal is disposed adjacent to one of said power-connected or ground-connected plated-through holes.

## Patentansprüche

1. Halbleiterschaltungsgehäuse (10) mit einer Vielzahl von dielektrischen Schichten (85), leitenden Kontakten (14) auf einer Fläche (13) einer der Schichten zur Herstellung von Verbindungen mit einem Halbleiterplättchen, das auf dem Gehäuse montiert werden soll, einer leitenden Masseschicht (19), einer leitenden Stromversorgungsschicht (20) und zwei Signalschichten (16, 17), die je zwischen einem unterschiedlichen Paar der dielektrischen Schichten angeordnet sind, wobei jede Signalschicht eine Vielzahl von im Abstand angeordneten Leitern (43, 37) besitzt, und mit durchplatierten Löchern (21), die durch einzelne der Schichten führen und unterschiedliche leitende Kontakte (14) mit unterschiedlichen leitenden Schichten verbinden, dadurch gekennzeichnet, daß das Verhältnis der Breite der Leiter (43) einer der Signalschichten (16) zum Abstand dieser Schicht von der nächsten Masseschicht (19) und nächsten Stromversorgungsschicht (19, 20) etwa gleich dem Verhältnis der Breite der Leiter der anderen Signalschicht (17) zum Abstand dieser Schicht zur nächsten Masseschicht (20) und zur nächsten Stromversorgungsschicht ist.

2. Gehäuse nach Anspruch 1, dadurch gekennzeichnet, daß die durchplatierten Löcher (71, 69), die mit der Stromversorungsschicht bzw. der Masseschicht verbunden sind, symmetrisch zueinander auf dem Gehäuse angeordnet sind und daß jedes dieser Löcher durch ein durchplatiertes Loch (65), das mit einer der Signalschichten verbunden ist, getrennt wird.

3. Gehäuse nach Anspruch 2, dadurch gekennzeichnet, daß jedes de durchplatierten Löcher (65—68), das mit einer Signalschicht verbunden ist, nahe einem der durchplatierten Löcher angeordnet ist, die mit einer Stromversorgungsschicht oder einer Masseschicht verbunden sind.

## Revendications

1. Un support de puce de semiconducteur (10), comprenant un ensemble de couches diélectriques (85), des contacts conducteurs (14) sur une surface (13) de l'une de ces couches, disposés pour être connectés à une puce de semiconducteur qui doit être montée sur le support, une couche conductrice de masse (9), une couche conductrice d'alimentation (20), et une paire de couches de signal (16, 17), chacune d'elles étant disposée entre une paire différente des couches diélectriques, chacune des couches de signal comprenant un ensemble de conducteurs mutuellement espacés (43, 37), et des trous métallisés (21) qui traversent certaines des couches et interconnect différents contacts permi les contacts conducteurs (14) avec différentes couches parmi les couches conductrices, carctérisé en ce que le rapport entre la largeur de conducteurs (43) de l'une des couches de signal (16), et la distance de cette couche à la couche la plus proche (19) parmi les couches de masse et d'alimentation (19, 20), est pratiquement égal au rapport entre la largeur de conducteurs de l'autre couche parmi les couches de signal (17), et la distance de cette autre couche jusqu'à la couche la plus proche (20) parmi les couches de masse et d'alimentation.

2. Le support selon la revendication 1, caractérisé en ce que les trous métallisés (71, 69) connectés respectivement aux couches d'alimentation et de masse, sont disposés symétriquement les uns par rapport aux autres sur le support, et chacun des trous métallisés connectés à l'alimentation et chacun des trous métallisés connectés à la masse sont séparés par un trou métallisé (65) qui est interconnecté à l'une des couches de signal.

3. Le support selon la revendication 2, caractérisé en ce que chacun des trous métallisés (65—68) connecté à un signal est disposé en position adjacente à l'un des trous métallisés connectés à l'alimentation ou connectés à la masse.

FIG. 1

EP 0 130 207 B1

# FIG. 2